# EUROPEAN PATENT SPECIFICATION

(11) **EP 3 439 031 B1**
(45) Date of publication and mention of the grant of the patent: **08.12.2021**
(21) Application number: 17184398.0
(22) Date of filing: 02.08.2017
(51) Int. Cl.: H01L 23/528, H01L 23/522

(54) **METHOD FOR FORMING A MULTI-LEVEL INTERCONNECT STRUCTURE**
VERFAHREN ZUR HERSTELLUNG EINER MEHRLAGIGEN VERBINDUNGSSTRUKTUR
PROCÉDÉ DE FORMATION D'UNE STRUCTURE D'INTERCONNEXION À NIVEAUX MULTIPLES

(43) Date of publication of application: 06.02.2019
(73) Proprietor: IMEC vzw, 3001 Leuven (BE)
(72) Inventor: BOEMMELS, Juergen, 3001 Leuven (BE); DEBACKER, Peter, 3001 Leuven (BE); GUPTA, Anshul, 3001 Leuven (BE)
(74) Representative: AWA Sweden AB

(56) References cited:
- US-A- 5 517 060
- US-A1- 2004 140 569
- US-A1- 2006 017 162
- US-A1- 2008 315 348

## Description

### Technical field

The present inventive concept relates to a method for forming a multi-level interconnect structure for a semiconductor device.

### Background

To provide dense semiconductor integrated circuits, modern circuit design typically includes multi-level interconnect structures. A multi-level interconnect structure may include a number of vertically stacked interconnection levels arranged in a dielectric layer. Adjacent interconnection levels may be interconnected by vertically extending connections known as vias.

An interconnection level may be formed by forming a pattern of conductive lines in the dielectric layer. A mask layer arranged on the dielectric layer may be patterned using lithographic techniques and etching. The pattern of the mask layer may subsequently be transferred into the dielectric layer by etching. A single patterning technique involving a single step of litho-etch may be used. Multiple patterning techniques like (litho-etch)^{x}, or pitch splitting techniques such as self-aligned double patterning (SADP) or quadruple patterning (SAQP) may also be used. Multi patterning techniques enables further down-scaling of the pitch of the line patterns (i.e. a reduction of the line widths and line spacing) to sub-lithographic dimensions.

Although dense lines patterns, in combination with modern semiconductor device fabrication, allow increasingly advanced, compact and power efficient integrated circuits, the reduced pitches of the interconnection levels may cause an increased resistance of the interconnect structure. This may have a negative impact on overall power efficiency and performance of the circuit. US 2006/017162 A1 discloses multi-level interconnect structures of the prior art and their methods of fabrication.

### Summary

An objective of the present inventive concept is to address this issue. Further and/or alternatives objectives may be understood from the following.

According to an aspect of the present inventive concept there is provided a method for forming a multi-level interconnect structure for a semiconductor device, the method comprising:
forming a first interconnection level including a set of conductive lines arranged in a first common horizontal plane of the first interconnection level and extending parallel to a first direction,
forming a second interconnection level, wherein forming the second interconnection level comprises:
   forming, on the first interconnection level, a first sub-level of the second interconnection level, the first sub-level including a set of conductive lines arranged in a first common horizontal plane of the second interconnection level and extending parallel to a second direction transverse to the first direction, covering the first sub-level with a dielectric layer, forming a via hole extending through said dielectric layer and the first sub-level to a line of said set of lines of the first interconnection level,
   filling the via hole with a conductive via material to form a via,
   covering said dielectric layer with an additional dielectric layer,
   forming, in said additional dielectric layer, a set of trenches for accommodating a set of lines of the second sub-level, wherein said set of trenches are formed such that a top portion of the via protrudes from a bottom of a trench of said set of trenches, and
   filling said set of trenches with a conductive line material to form said set of lines of the second sub-level,
   wherein said set of conductive lines of the second sub-level are arranged in a second common horizontal plane of the second interconnection level, extend parallel to the second direction and are horizontally displaced from the set of lines of the first sub-level, and
   wherein the via extends past said set of lines of the first sub-level in a space between a pair of adjacent lines of said set of lines of the first sub-level.

The present inventive concept is based on the technical insight that a conventional single interconnection level may be split into, or replaced with, two sub-interconnection levels including sets of parallel lines. This split design allows the pitches of the lines of the sub-levels to be relaxed compared to a conventional single interconnection level as the lines may be distributed between two levels. By "pitch" is hereby meant a line width and a line spacing within a horizontal plane.

Merely arranging an interconnection level to include two sub-levels per se could cause a reduced overall routing density of the interconnection structure. The present inventive concept however enables the routing density to be maintained by a vertical via providing a direct interconnection between a pair of lines of two interconnection levels (at least one being a sub-level of a first or second interconnection level).

The interconnection provided by the via may be referred to as a "direct" vertical interconnection: In accordance with the first and third aspect, a line of said set of lines of the first interconnection level and a line of said set of lines of the second sub-level of the second interconnection level may be interconnected by the via while the via (electrically) bypasses the first sub-level of the second interconnection level. In accordance with the second and fourth aspect, a line of said set of lines of the first sub-level of the first interconnection level and a line of said set of lines of the second interconnection level may be interconnected by the via while the via (electrically) bypasses the second sub-level of the first interconnection level.

Said vertical vias may accordingly be referred to as "multilayer vias" or "supervias" since it has a physical extension exceeding the separation between two adjacent (sub-)levels.

By the set of lines of the two sub-levels being horizontally displaced in relation to each other the set of lines of the two sub-levels may be arranged in an interleaved manner. This facilitates forming of a vertical via to extend through a sub-level without interfering with the lines of sub-level. That is, a via may be formed to extend in a vertical straight-line path from a line of one sub-level through a space or gap formed between a pair of consecutive lines of the other the sub-level and to a connecting line.

A further merit of the present inventive concept is that introduction of sub-levels need not result in any significant increased of the complexity of the process or the number of litho-etch steps. Since the sub-levels allows forming of the lines of the sub-levels at relaxed pitches, there may be less need to use multi-patterning techniques forming the lines of the sub-levels. For instance, even single patterning techniques may be used.

As used herein, the term "horizontal" direction or "horizontal" plane denotes a direction or plane being parallel to a main plane of extension of any of the interconnection levels. The multi-layer interconnection structure may be supported by a substrate wherein the term "horizontal" direction or "horizontal" plane equivalently may be understood as a direction parallel to a main plane of extension of the substrate.

As used herein, the term "vertical" direction or "vertical" plane denotes a direction or plane being perpendicular to a horizontal direction or horizontal plane. I.e. the term "vertical" direction or "vertical plane" denotes a direction or plane being perpendicular to a main plane of extension of any of the interconnection levels, or of a substrate supporting the interconnection structure.

Accordingly, the terms "above" and "below" refer to directions along the vertical direction and opposite to the vertical direction, respectively.

By "interconnection level" is hereby meant a level, or a tier, of an interconnection structure of the device. An interconnection level may also be referred to as a metallization or a routing level.

Each interconnection level includes at least one set of parallel conductive lines arranged in a common horizontal plane. The set of conductive lines of each interconnection level may be arranged to provide a horizontal routing of (electrical) signals, i.e. a routing within the common horizontal plane of the set of conductive lines.

Each set of conductive lines may be regularly spaced lines. The material lines may be spaced apart such that longitudinal gaps are formed between the lines. The gaps may present a regular width and spacing. Advantageously, the lines may, at least along a portion thereof, extend in a straight line and present a uniform width or substantially uniform width. This applies accordingly to the gaps between the lines.

Each set of lines may be arranged in a dielectric layer of the respective interconnection (sub-)level. A dielectric layer may be formed as a single material layer, or as a compound layer including a stack of sub-layers formed of different materials.

By "via" as used herein is meant a conductive structure extending in a vertical direction between lines of different interconnection levels. The interconnect structure may, in addition to the afore-mentioned multi-level vias, also include vertical "single-level" vias. By "single-level" via is hereby meant a via for interconnecting lines of two consecutive interconnection (sub-)levels. Vias of the interconnect structure may hence be arranged to provide a vertical routing of (electrical) signals, i.e. a routing perpendicular to the set of conductive lines.

According to embodiments, filling the via hole includes depositing the conductive via material in the via hole by an electro-less deposition process. This enables selective deposition of the conductive via material in the via hole. Reliable filling of the via hole may hence be provided even in case of via holes with comparably high aspect ratios.

The via hole may be filled completely with the conductive via material. The via hole may be over-filled wherein excess conductive via material may be removed subsequently. The via hole may be partially filled wherein a thickness of the dielectric layer (through which the via hole extends) may be reduced such that an upper surface of the dielectric layer becomes flush with an upper surface of the via.

According to embodiments , the method may further comprise forming a dielectric liner in the via hole prior to filling the via hole with the conductive via material. A dielectric liner may provide a double-function of acting as a diffusion barrier for the conductive via material and enabling an improved time-dependent dielectric breakdown performance.

According to advantageous embodiments, both the first and the second interconnection levels may be formed or arranged to include a first and a second sub-level.

### Brief description of the drawings

The above, as well as additional objects, features and advantages of the present inventive concept, will be better understood through the following illustrative and non-limiting detailed description, with reference to the appended drawings. In the drawings like reference numerals will be used for like elements unless stated otherwise.
Figures 1A-B are schematic illustrations of a multi-level interconnect structure.
Figures 2A-C are schematic illustrations of an alternative multi-level interconnect structure.
Figures 3A-C through 19A-C schematically illustrate a method for forming a multi-level interconnect structure.

### Detailed description

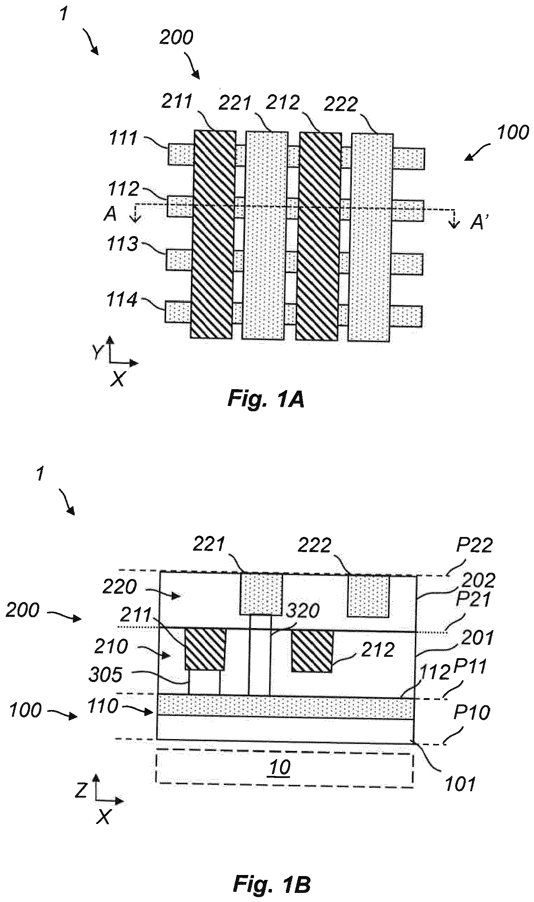

With reference to figure 1A there is shown a schematic top-view of a multi-level interconnect structure 1. Figure 1B shows the interconnect structure 1 along the plane of section AA' indicated in Figure 1A. In figures 1A and 1B, as well as the further figures, the indicated directions X, Y and Z consistently refer to a first horizontal direction, a second horizontal direction and a vertical direction, respectively. It should be noted that the structure 1 may extend laterally or horizontally beyond the illustrated portions. It should further be noted that, owing to the schematic nature of the drawings, the relative dimensions of the various structures and layers are not drawn to scale. Rather, the dimensions have been adapted for illustrational clarity and to facilitate understanding of the following description.

The interconnect structure 1 may as schematically indicated be arranged on a substrate 10. The substrate 10 may be a semiconductor wafer or substrate, for instance a Si substrate, a Ge substrate, a SiGe substrate, a SiC substrate, a SOI substrate, a GeOI substrate, a SiGeOI substrate to name a few examples.

The substrate 10 may support an active device layer including active devices, for instance semiconductor devices such as transistors and other solid state devices. The active devices may have been formed using conventional front-end-of-line (FEOL) processing. The interconnect structure 1 together with the substrate 10 and the active devices may form part of an integrated circuit.

The multi-level interconnect structure 1 comprises in a bottom-up direction a first interconnection level 100 and a second interconnection level 200. The first interconnection level 100 and the second interconnection level 200 form consecutive levels of the interconnect structure 1.

The first interconnection level 100 includes a set of conductive lines 111-114 arranged in a first common horizontal plane (indicated by P11 in figure 1B) of the first interconnection level 100. The set of lines 111-114 are mutually parallel and extend in parallel to the first direction X. The first interconnection level 100 extends between the horizontal planes indicated by P10 and P11. P11 coincides with the top-most surface of the set of conductive lines 111, 112 of the first interconnection level 100. P11 represents an interface between the first interconnection level 100 and the second interconnection level 200. The first interconnection level 100 includes only a single co-planar set of conductive lines. The first interconnection level 100 may hence be referred to as a single-level interconnection level or non-split interconnection level. Although the figures only show interconnection levels including sets of four conductive lines, each interconnection level may in practice include a much greater number of lines than four.

The second interconnection level 200 includes two co-planar sets of conductive lines, the set of lines 211, 212 and the set of lines 221, 222. The two sets of lines are arranged at different levels within the second interconnection level 200. The second interconnection level 200 hence includes, or is split into, a first sub-level 210 including the set of lines 211, 212 and a second consecutive sub-level 220 including the set of lines 221, 222. The second interconnection level 200 may hence be referred to as a dual-level interconnection level or split interconnection level.

The first sub-level 210 of the second interconnection level 200 is arranged directly on the first interconnection level 100. The second sub-level 220 is arranged directly on the first sub-level 210 of the second interconnection level 200.

The second interconnection level 200 extends between the horizontal planes P11 and P22. The first sub-level 210 of the second interconnection level 200 extends between the horizontal planes P11 and P21. The second sub-level 220 of the second interconnection level 200 extends between the horizontal planes P21 and P22. The plane P21 coincides with the top-most surface of the set of conductive lines 211, 212 of the first sub-level 210. P21 represents an interface between the first sub-level 210 and the second sub-level 220. The plane P22 coincides with the top-most surface of the set of conductive lines 221, 222 of the second sub-level 220.

The first sub-level 210 includes a set of conductive lines 211, 212 arranged in a first common horizontal plane (indicated by P21 in figure 1B) of the second interconnection level 200. The set of lines 211, 212 are mutually parallel and extend in parallel to the second direction Y, which is perpendicular to the first direction X.

The second sub-level 220 includes a set of conductive lines 221, 222 arranged in a second common horizontal plane (indicated by P22 in figure 1B) of the second interconnection level 200. The set of lines 221, 222 are mutually parallel and extend in parallel to the second direction Y.

The set of lines 211, 212 of the first sub-level 210 and the set of lines 221, 222 of the second sub-level 220 are horizontally displaced in relation to each other, along the first horizontal direction X. The interleaved and nonoverlapping arrangement of the two sets of lines 211, 212 and 221, 222 may be seen in figure 1A and 1B.

As indicated in Fig. 1A, the pitch of the set of lines 211, 212 of the first sub-level 210 is greater than the pitch of the set of lines 111-114 of the first interconnection level 100. Correspondingly, the pitch of the set of lines 221, 222 of the second sub-level 220 is greater than the pitch of the set of lines 111-114 of the first interconnection level 100. The increased pitch also allows an increased height or thickness of the lines 211, 212.

The set of conductive lines 111-114 of the first interconnection level 100 and the set of conductive lines 211, 212, 221, 222 may be formed by a metal or an alloy, or some other suitable conductive material. The sets of lines may for instance be formed by Cu, Al or W.

The set of conductive lines 111-114 are embedded in a dielectric layer 101 of the first interconnection level 100. The set of conductive lines 211, 212 are embedded in a dielectric layer 201 of the first sub-level 210 of the second interconnection level 200. Correspondingly, the set of conductive lines 221, 222 are embedded in a dielectric layer 202 of the second sub-level 220 of the second interconnection level 200. Each of the dielectric layers 102, 202, 204 may include or be formed of silicon dioxide or some other low-κ material. The dielectric layer may also include a stack of sub-layers of different dielectric materials. The dielectric layer may for instance include sub-layers forming interface layers, diffusion layers and/or capping layers.

With reference to figure 1B, the interconnect structure 1 includes a vertical via 320 for interconnecting the line 112 of the first interconnection level 100 and the line 221 of the second sub-level 220 of the second interconnection level 200. The via 320 extends from the line 221 of the second sub-level 220, in the vertical direction Z, to the line 112 of the first interconnection level 100. The via 320 extends through the first sub-level 210 of the second interconnection level 200 and past the set of lines 211, 212 of the first sub-level 210 in a space between the lines 211, 212. Thus the via 320 is horizontally spaced apart from the lines 211, 212. The via 320 accordingly provides a direct electrical interconnection between a line 221 of the second sub-level 220 and a line 112 of the first interconnection level 100 without any intermediate electrical connection with lines of the first sub-level 210. Accordingly, the via 320 is electrically insulated from the set of lines 211, 212.

As shown, the interconnect strucure 1 may further include a single-level via 305 for interconnecting a line 211 of the first sub-level 210 of the second interconnection level 200 with a line 112 of the first interconnection level 100.

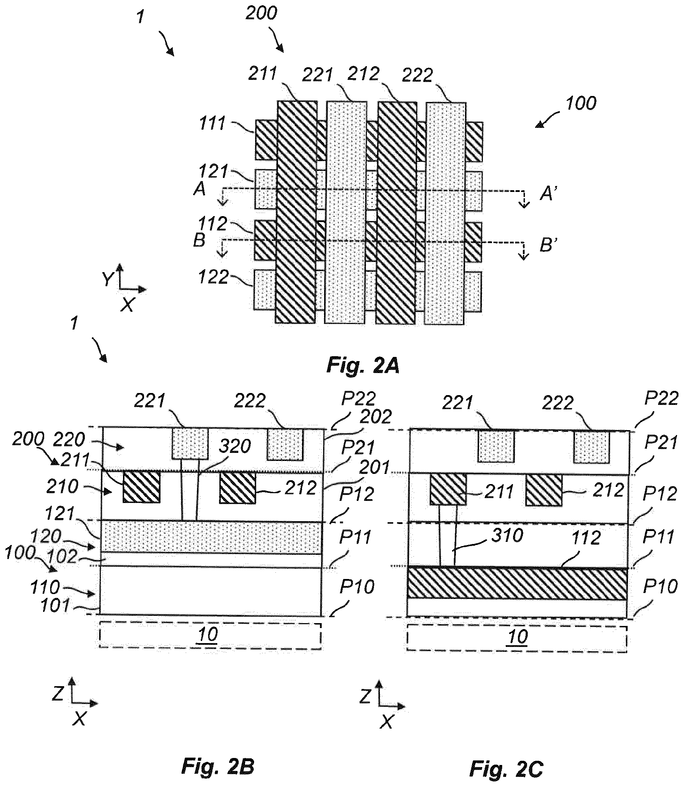

With reference to figure 2A there is shown a schematic top-view of a multi-level interconnect structure 1 wherein both the first interconnection level 100 and the second interconnection level 200 are split into two sub-levels 110, 120 and 210, 220 respectively. Figure 2B shows the interconnect structure 1 along the plane of section AA' indicated in Figure 2A. Figure 2C shows the interconnect structure 1 along the plane of section BB' indicated in Figure 2A.

The description of the second interconnection level 200 in connection with figure 1A and 1B applies correspondingly to the second interconnection level 200 shown in figures 2A-C.

The first interconnection level 100 comprises a first sub-level 110 and a second sub-level 120. The first sub-level 110 includes a set of conductive lines 111, 112 arranged in a first common horizontal plane (indicated by P11 in figure 2B and 2C) of the first interconnection level 100. The set of lines 111, 112 are mutually parallel and extend in parallel to the first direction X. The second sub-level 120 is arranged directly on the first sub-level 110 of the first interconnection level 100. The second sub-level 120 includes a set of conductive lines 121, 122 arranged in a second common horizontal plane (indicated by P12 in figures 2B and 2C) of the first interconnection level 100. The set of lines 121, 122 are mutually parallel and extend in parallel to the first direction X.

The set of lines 111, 112 of the first sub-level 110 and the set of lines 121, 122 of the second sub-level 120 are horizontally displaced in relation to each other, along the second horizontal direction Y. The interleaved and nonoverlapping arrangement of the two sets of lines 111, 112 and 121, 122 may be seen in figure 2B and 2C.

The first interconnection level 100 extends between the horizontal planes P10 and P12. The first sub-level 110 of the first interconnection level 100 extends between the horizontal planes P10 and P11. The second sub-level 120 of the first interconnection level 100 extends between the horizontal planes P11 and P12. The plane P11 coincides with the top-most surface of the set of conductive lines 111, 112 of the first sub-level 110. P11 represents an interface between the first sub-level 110 and the second sub-level 120. The plane P12 coincides with the top-most surface of the set of conductive lines 121, 122 of the second sub-level 120.

The set of conductive lines 111, 112 are embedded in a dielectric layer 101 of the first sub-level 110 of the first interconnection level 100. The set of conductive lines 121, 122 are embedded in a dielectric layer 102 of the second sub-level 210 of the first interconnection level 100.

The interconnect structure 1 includes a via 310 for interconnecting a line 112 of the set of lines 111, 112 of the first sub-level 110 of the first interconnection level 100 and a line 211 of the set of lines 211, 212 of the first sub-level 210 of the second interconnection level 200. The via 310 extends through the second sub-level 120 of the first interconnection level 100 and past the set of lines 121, 122 of the second sub-level 120 in a space between the lines 121, 222. Thus the via 310 is horizontally spaced apart from the lines 121, 122. The via 310 accordingly provides a direct electrical interconnection between a line 112 of the first sub-level 110 of the first interconnection level 100 and a line 211 of the first sub-level 210 of the second interconnection level 200 without any intermediate electrical connection with lines of the second sub-level 120. Accordingly, the via 310 is electrically insulated from the set of lines 121, 122. Although not shown in the figures, a corresponding via may be formed to interconnect the line 212 of the first sub-level 210 of the second interconnection level 200 and the line 111 of the first sub-level 110 of the first interconnection level 100.

The interconnect structure 1 includes a via 320 corresponding to the via 320 shown in Figure 1B. The via 320 interconnects a line 121 of the set of lines 121, 122 of the second sub-level 120 of the first interconnection level 100 and a line 221 of the set of lines 221, 222 of the second sub-level 220 of the second interconnection level 200. The via 320 extends through the first sub-level 210 of the second interconnection level 200. Although not shown in the figures, a corresponding via may be formed to interconnect the line 222 of the second sub-level 220 of the second interconnection level 200 and the line 122 of the second sub-level 120 of the first interconnection level 100.

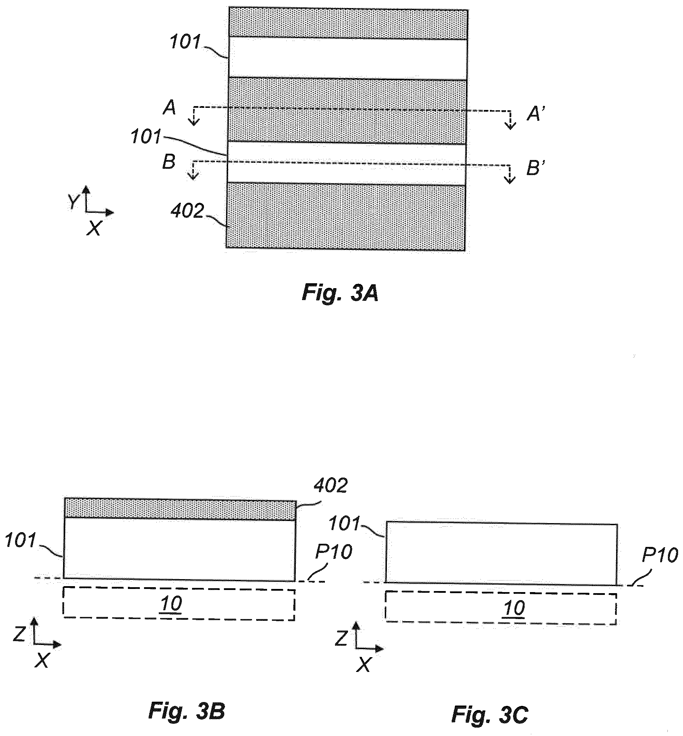

A method for forming an interconnection structure 1 as shown in figures 2A-C will now be described with reference to figures 3A-C through 19A-C. As may be understood, a sub-set of the following method steps may be performed to form an interconnection structure 1 as shown in figures 1A-B. In the following, partial-view A corresponds to the top-view shown in figure 2A, partial-view B corresponds to the section along the plane AA' and partial-view C corresponds to the section along the plane BB'.

In figures 3A-C, a dielectric layer 101 has been formed on the substrate 10. A mask layer 402 has been formed on the dielectric layer 101 and patterned to include trenches exposing the dielectric layer 101. The mask layer 402 may be patterned using single or multi-patterning techniques. The mask layer 402 may be a hard mask layer, for instance of a hard mask material such as titanium nitride, titanium oxide, hafnium oxide, zirconium oxide or a ruthenium or aluminum alloy, deposited by any suitable deposition method such as atomic layer deposition (ALD), chemical vapor deposition (CVD) or physical vapor deposition (PVD). The mask layer 402 may also be a layer of a-C, a-Si, spin-on-carbon (SOC), SiCN or even a photoresist.

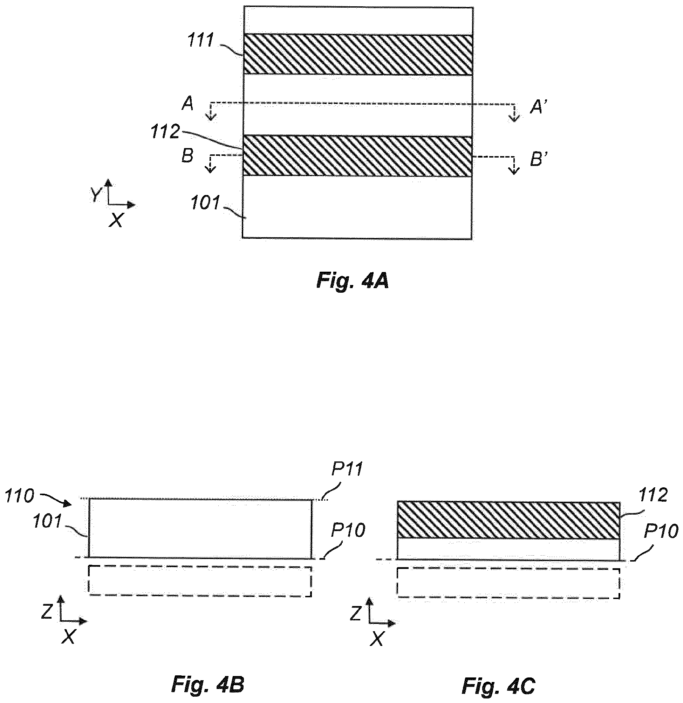

In figures 4A-C the trenches in the mask layer 402 have been transferred into the dielectric layer 101 by etching while using the mask layer 402 as an etch mask. Trenches for accommodating a set of lines of a first sub-level 110 of a first interconnection level 100 have thereby been formed in the dielectric layer 101. The pattern transfer may be performed by an anisotropic etch process. The etch process may be a plasma-based etching process. The etch process may be a reactive ion etching (RIE) process. For instance, F-based plasmas may be used for selectively etching a silicon oxide-based dielectric layer 101 with respect to a hard mask layer.

The trenches in the dielectric layer 101 have been filled with a conductive line material, to form the set of lines 111, 112 of the first sub-level 110 of the first interconnection level 100. The conductive line material may for instance be Al, Cu or W. The trenches may be filled using an electro-plating process, or a deposition process such as CVD or ALD. Any conductive material overfilling the trenches may be removed by etch back and/or chemical mechanical polishing (CMP).

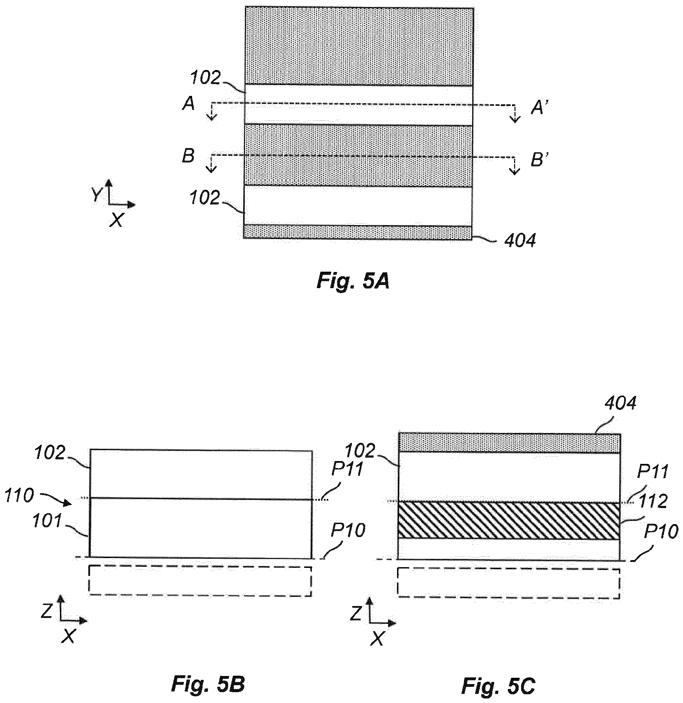

In figures 5A-C a dielectric layer 102 has been formed on the first sub-level 110. A mask layer 404 has been formed on the dielectric layer 102 and patterned to include trenches exposing the dielectric layer 102. The mask layer 404 may be formed and patterned using any of the materials and techniques discussed in connection with the mask layer 402.

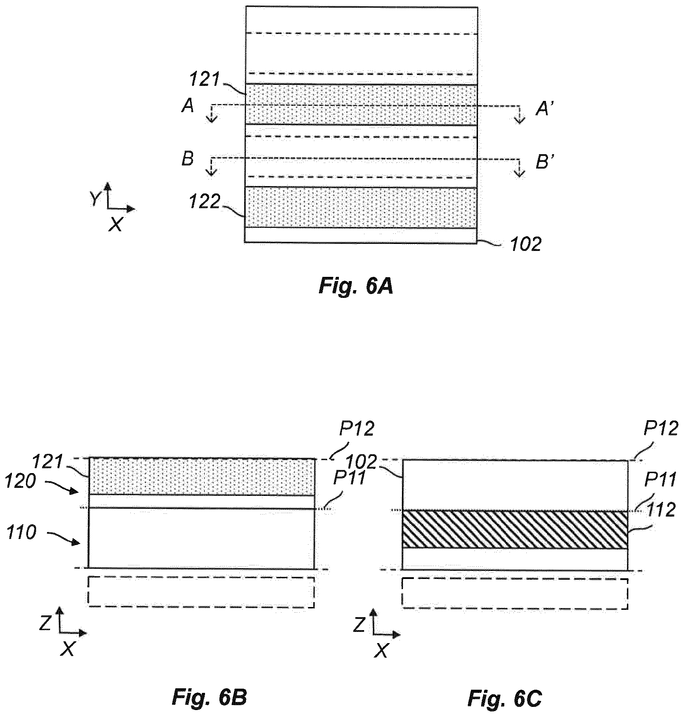

In figures 6A-C the trenches in the mask layer 404 have been transferred into the dielectric layer 102 by etching while using the mask layer 404 as an etch mask. Trenches for accommodating a set of lines of a second sub-level 120 of the first interconnection level 100 have thereby been formed in the dielectric layer 102. The dielectric layer 102 may be etched using any of the etching processes discussed in connection with the patterning of the dielectric layer 101. The trenches in the dielectric layer 102 have subsequently been filled with a conductive line material, to form the set of lines 121, 122 of the second sub-level 120 of the first interconnection level 100. The conductive line material may be any of the materials discussed in connection with the filling of the trenches in the dielectric layer 101. In Fig. 6A the positions of the set of lines 111, 112 of the first sub-level 110 are indicated by dashed lines.

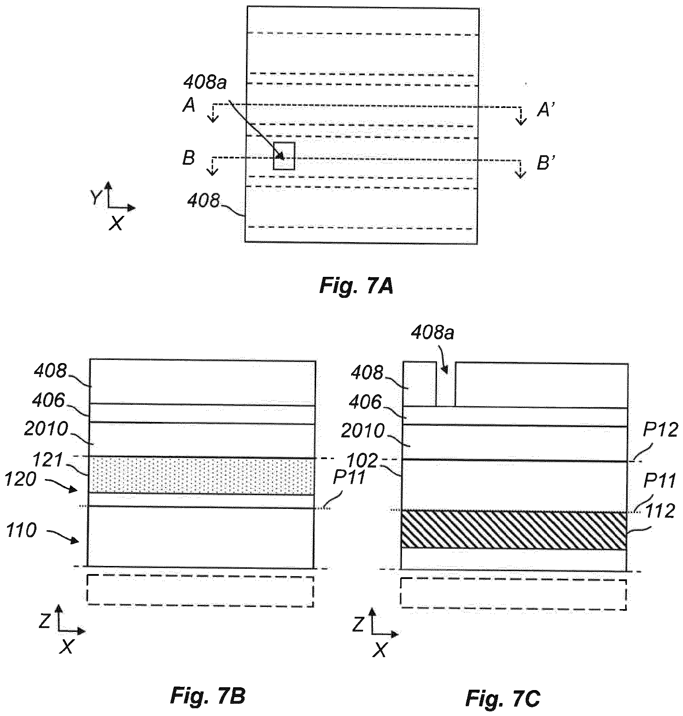

In figures 7A-C a dielectric layer 2010 has been formed to cover the second sub-level 120 of the first interconnection level 100. A mask layer 406 has been formed to cover the dielectric layer 2010. The mask layer 406 may for instance be a hard mask layer of any of the afore-mentioned hard mask materials. A photo resist layer 408 has been formed on the mask layer 406 and patterned to include an opening 408a. The opening 408a defines a position of a via hole, to be transferred into the below layers.

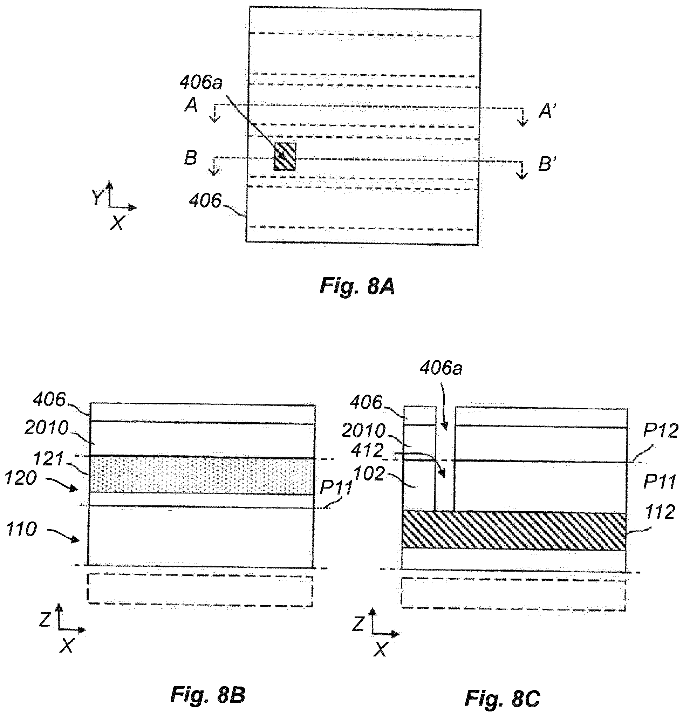

In figures 8A-C the opening 408a has been transferred into the mask layer 406 to form an opening 406a in the mask layer 406. The opening 406a has subsequently been further transferred into the dielectric layer 2010 and the dielectric layer 102 to form a via hole 412 exposing an upper surface of the line 112 of the first sub-level 110 of the first interconnection level 100. During the etching of the via hole 412 the photo resist layer 408 may as shown be consumed. The via hole 412 may be formed using an anisotropic etching process, such as a RIE-process.

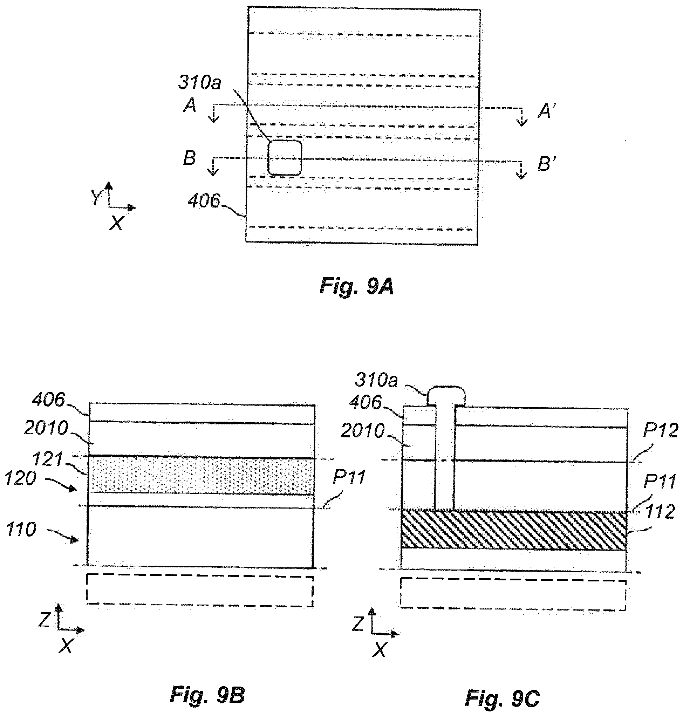

In figures 9A-C, the via hole 412 has been filled with a conductive via material. The via hole 412 may be filled by depositing the conductive via material in the via hole 412 by an electro-less deposition (ELD) process. For instance, Co, Ru or Ni may be deposited using ELD. An ELD process may result in a bottom-up growth of the conductive via material from the exposed surface of the line 112. An intermediate via structure 310a, protruding from the via hole 412 has accordingly been formed. As an alternative to ELD, the via hole 412 may be filled by depositing a conductive via material by CVD and removing material deposited outside the via hole 412 by CMP. The via hole 412 need not be filled completely with the conductive via material but a partial filling is also possible provided the via hole 412 is filled to a level matching at least an intended final via height.

Prior to filling the via hole 412 with a conductive via material, a dielectric liner may be formed on the sidewalls in the via hole 412 (not shown in the figures). The liner may for instance be formed by SiOx, SiN, SiCN or SiCO. The liner may be deposited as a conformal layer, for instance by ALD.

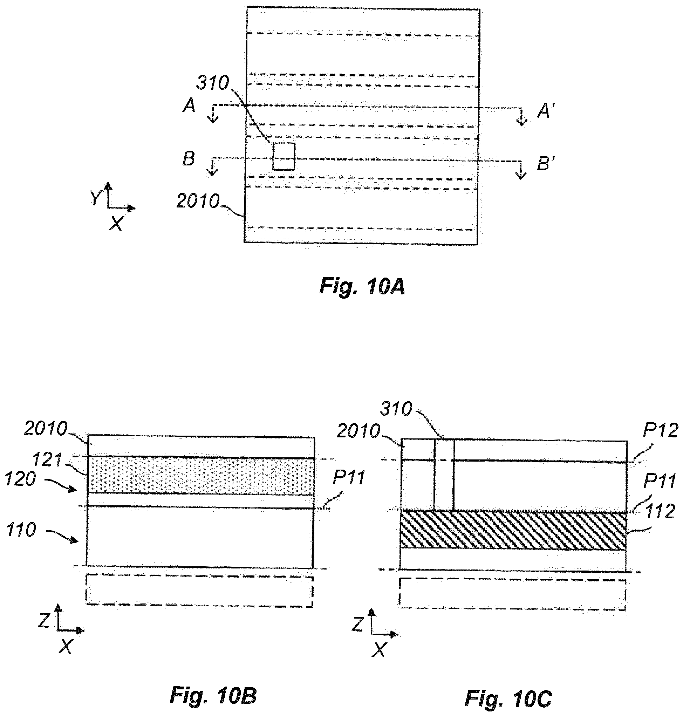

In figures 10A-C, the structure has been planarized wherein the protruding portion of the intermediate via structure 310a has been removed. The planarization may include etch back and/or CMP. The planarization may further result in the removal of the mask layer 406 and removal of portions of the liner (if deposited) outside the via hole 412. The planarization may also result in a thickness reduction of the dielectric layer 2010. The remaining part of the intermediate via structure 310a forms the final via 310. If the via hole 412 only has been partially filled with the conductive via material, the thickness of the dielectric layer 2010 may be reduced until an upper surface of the dielectric layer 2010 is coplanar with an upper surface of the via structure 310.

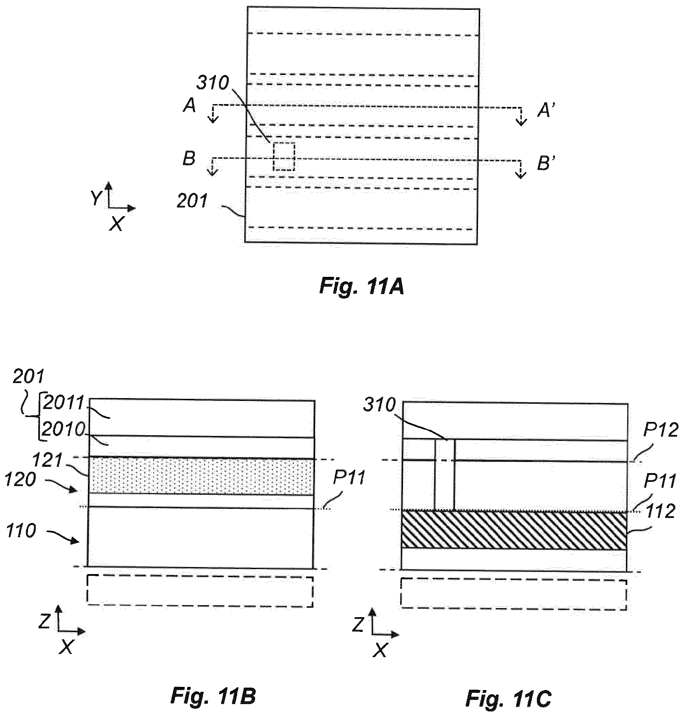

In figures 11A-C an additional dielectric layer 2011 has been formed to cover the dielectric layer 2010. The additional dielectric layer 2011 may include a silicon dioxide layer or some other low-κ material layer. To avoid direct contact between low-κ material layer and a top surface of the via 310, the dielectric layer 2011 may include a protection layer of for instance SiCN formed below the low-κ material layer. The layers 2010 and 2011 form part of a compound dielectric layer 201 of a first sub-level 210 of a second interconnection level 200.

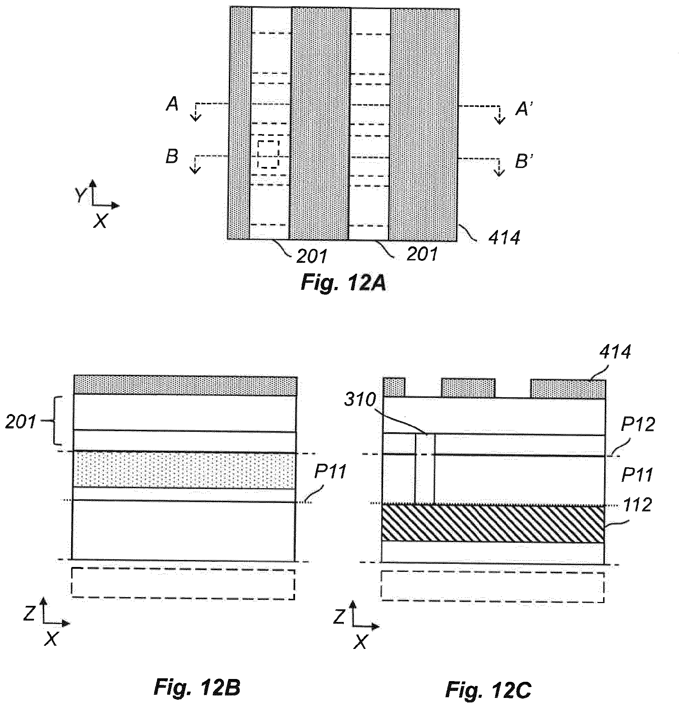

In figures 12A-C a mask layer 414 has been formed on the dielectric layer 201 of the first sub-level 210 of a second interconnection level 200 and patterned to include trenches exposing the dielectric layer 201. The mask layer 414 may be formed and patterned using any of the materials and techniques discussed in connection with the mask layer 402. In Fig. 12A the positions of the set of lines 111, 112 of the first sub-level 110, the set of lines 121, 122 of the second sub-level 120 as well as the position of the via 310 are indicated by dashed lines.

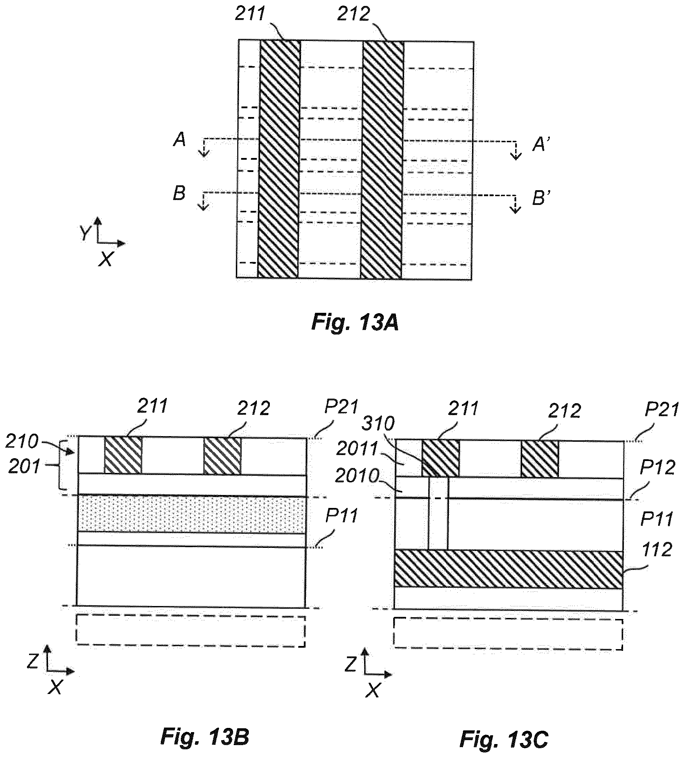

In figures 13A-C the trenches in the mask layer 414 have been transferred into the dielectric layer 201 by etching while using the mask layer 414 as an etch mask. Trenches for accommodating a set of lines of a first sub-level 210 of a second interconnection level 200 have thereby been formed in the dielectric layer 201. The dielectric layer 201 may be etched using any of the etching processes discussed in connection with the patterning of the dielectric layer 101 of the first sub-level 110 of the first interconnection level 100.

The trenches extend through the dielectric layer 2011 and into the dielectric layer 2010. The set of trenches are formed such that one of the trenches thereof (i.e. the trench for accommodating the line 211) is aligned along the vertical direction with the via 310. Following the trench formation, a top portion of the via 310 may accordingly protrude from a bottom of said trench. Alternatively, the trenches may be formed to extend only through the dielectric layer 2011 such that an upper surface of the top portion of the via 310 is exposed at a bottom of the trench.

In figures 13A-C, the trenches in the dielectric layer 201 have been filled with a conductive line material, to form the set of lines 211, 212 of the first sub-level 210 of the second interconnection level 200. The conductive line material may be any of the materials discussed in connection with the filling of the trenches in the dielectric layer 101. The line 211 is hence formed on the top portion of the via 310.

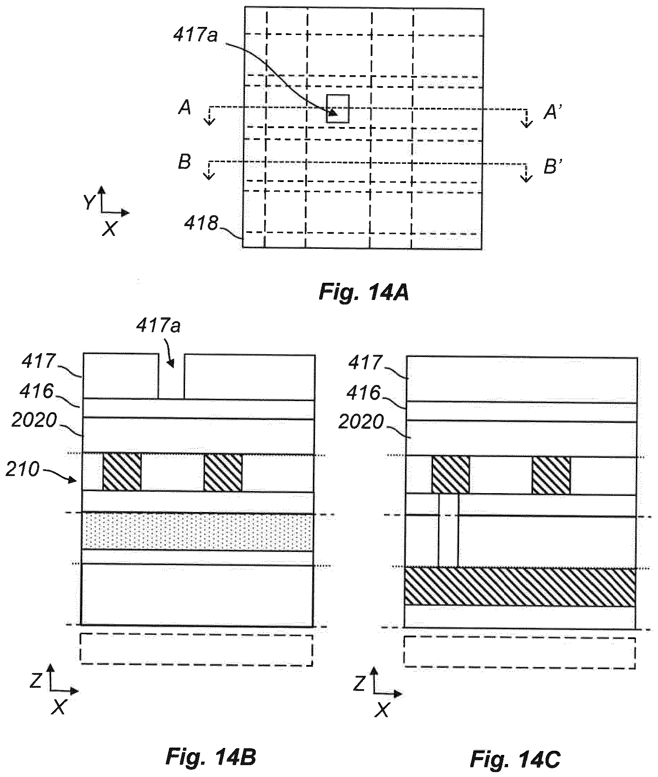

In figures 14A-C a dielectric layer 2020 has been formed to cover the first sub-level 210 of the second interconnection level 200. A mask layer 416 has been formed to cover the dielectric layer 2020. The mask layer 416 may for instance be a hard mask layer of any of the afore-mentioned hard mask materials. A photo resist layer 417 has been formed on the mask layer 416 and patterned to include an opening 417a. The opening 417a defines a position of a via hole, to be transferred into the below layers.

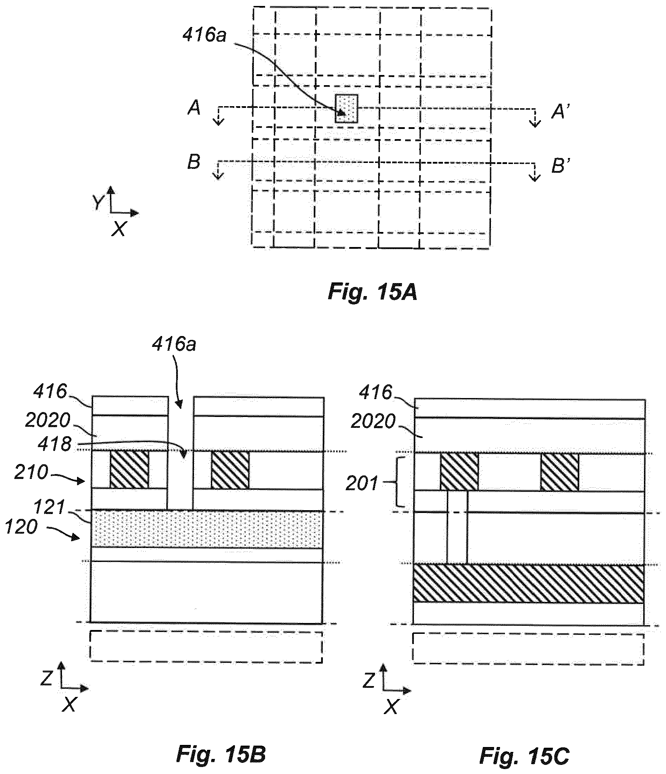

In figures 15A-C the opening 417a has been transferred into the mask layer 416 to form an opening 416a in the mask layer 416. The opening 416a has subsequently been further transferred into the dielectric layer 2020 and the dielectric layer 201 of a first sub-level 210 of a second interconnection level 200 to form a via hole 418 exposing an upper surface of the line 121 of the second sub-level 120 of the first interconnection level 100. During the etching of the via hole 418 the photo resist layer 417 may as shown be consumed. The via hole 418 may be formed using any of the etching processes discussed in connection with the via hole 412.

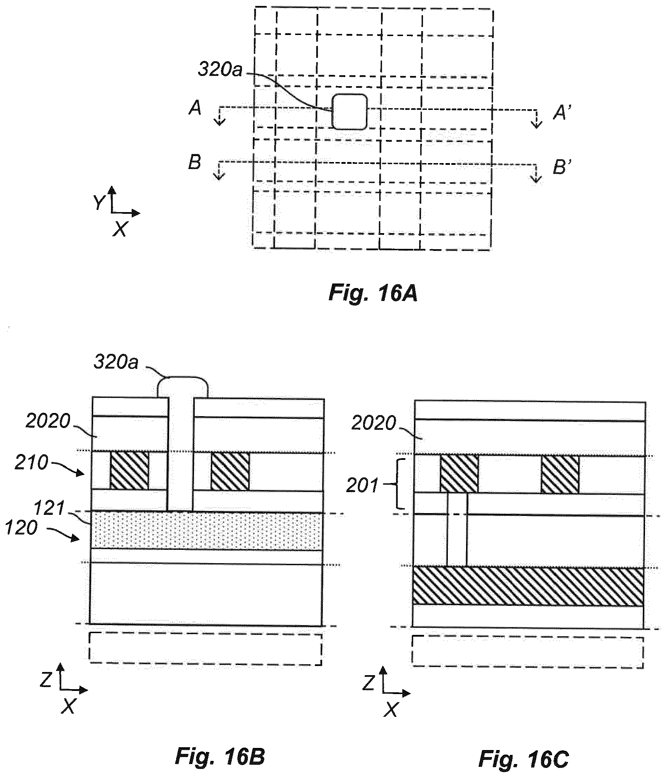

In figures 16A-C, the via hole 418 has been filled with a conductive via material. The via hole 418 may be filled by depositing the conductive via material in the via hole 418 in a same manner as the via hole 412, as disclosed in connection with figures 9A-C. An intermediate via structure 320a, protruding from the via hole 418 has accordingly been formed. Analogous to the via hole 412, a dielectric liner may be formed also in the via hole 418 prior to the filling thereof.

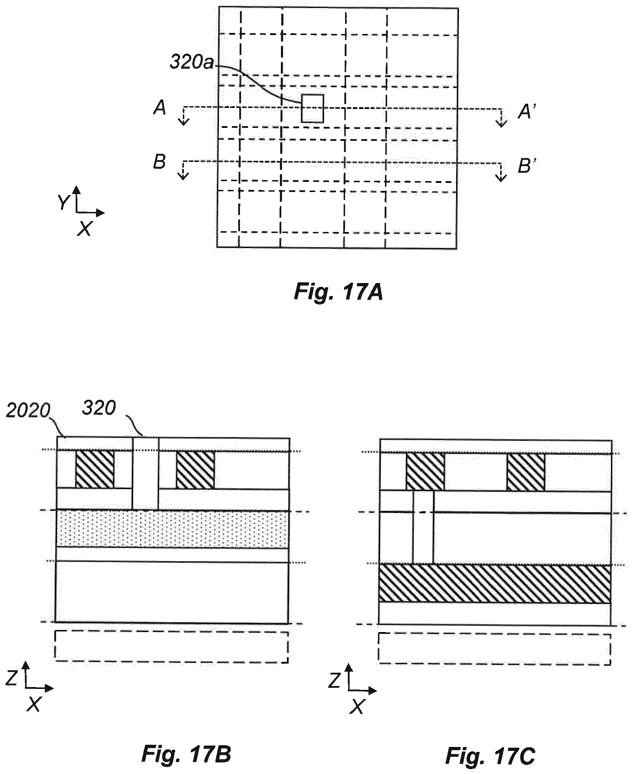

In figures 17A-C, the structure has been planarized wherein the protruding portion of the intermediate via structure 320a has been removed. The planarization may include etch back and/or CMP. The planarization may further result in the removal of the mask layer 416 and removal of portions of the liner (if deposited) outside the via hole 418. The planarization may also result in a thickness reduction of the dielectric layer 2020. The remaining part of the intermediate via structure 320a forms the final via 320.

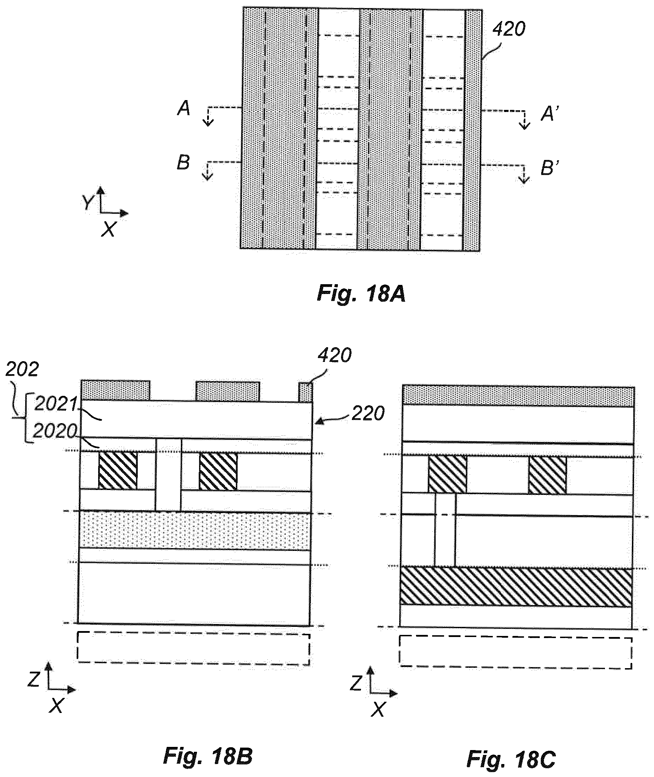

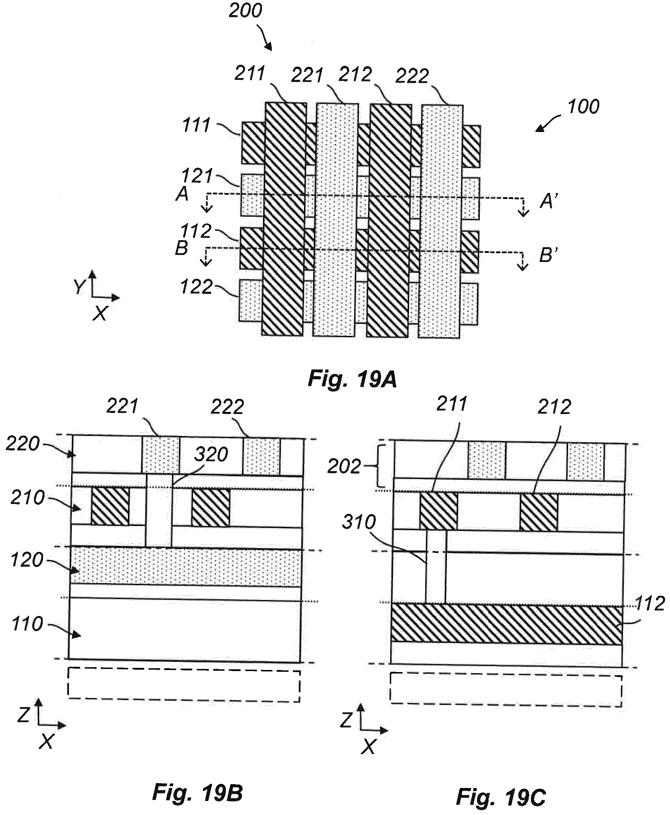

In figures 18A-C and 19A-C, process steps corresponding to those described in connection with figures 11A-C through 13A-C have been performed. More specifically, an additional dielectric layer 2021 (corresponding to the dielectric layer 2011) has been formed to cover the dielectric layer 2020 to form a compound dielectric layer 202 of a second sub-level 220 of the second interconnection level 200. A mask layer 420 has been formed on the dielectric layer 202 and patterned to include trenches exposing the dielectric layer 202.

The trenches in the mask layer 420 have been transferred into the dielectric layer 202 by etching while using the mask layer 420 as an etch mask. Trenches for accommodating a set of lines of the second sub-level 220 have thereby been formed in the dielectric layer 202. The set of trenches are formed such that one of the trenches thereof (i.e. the trench for accommodating the line 221) is aligned in the vertical direction with the via 320. Following the trench formation, a top portion of the via 310 may accordingly protrude from a bottom of said trench. The trenches in the dielectric layer 202 have subsequently been filled with a conductive line material, to form the set of lines 221, 222 of the second sub-level 220. The line 221 is hence formed on the top portion of the via 320.

The above method steps may be repeated to form further interconnection levels such as third and fourth interconnection levels above the second interconnection level 200. Although the figures only illustrate a first and a second interconnection level 100, 200 it should be noted that the multi-level interconnect structure 1 may include further interconnection levels arranged below the first interconnection level 100. The further lower interconnection levels may include non-split tight pitch interconnection levels and/or interconnection levels split into two sub-levels.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A method for forming a multi-level interconnect structure for a semiconductor device, the method comprising:
forming a first interconnection level (100) including a set of conductive lines (111, 112, 113, 114) arranged in a first common horizontal plane of the first interconnection level (100) and extending parallel to a first direction,
forming a second interconnection level (200), wherein forming the second interconnection level (200) comprises:
forming, on the first interconnection level (100), a first sub-level (210) of the second interconnection level (200), the first sub-level (210) including a set of conductive lines (211, 212) arranged in a first common horizontal plane of the second interconnection level (200) and extending parallel to a second direction transverse to the first direction,
covering the first sub-level (210) with a dielectric layer (2020),
forming a via hole (418) extending through said dielectric layer (2020) and the first sub-level (210) to a line (112) of said set of lines of the first interconnection level (100),
filling the via hole (418) with a conductive via material to form a via (320),
covering said dielectric layer (2020) with an additional dielectric layer (2021),
forming, in said additional dielectric layer, a set of trenches for accommodating a set of lines of the second sub-level (220), wherein said set of trenches are formed such that a top portion of the via (320) protrudes from a bottom of a trench of said set of trenches, and
filling said set of trenches with a conductive line material to form said set of lines of the second sub-level (220),
wherein said set of conductive lines (221, 222) of the second sub-level are arranged in a second common horizontal plane of the second interconnection level (200), extend parallel to the second direction and are horizontally displaced from the set of lines (211, 212) of the first sub-level (210), and
wherein the via (320) extends past said set of lines (211, 212) of the first sub-level (210) in a space between a pair of adjacent lines (211, 212) of said set of lines (211, 212) of the first sub-level (210).

2. A method according to claim 1, wherein filling the via hole (412, 418) includes depositing the conductive via material in the via hole by an electro-less deposition process.

3. A method according to claim 1 or 2, further comprising forming a dielectric liner in the via hole (412, 418) prior to filling the via hole with the conductive via material.

4. A method according to any of the preceding claims, wherein forming the first interconnection level (100) and forming the second interconnection level (200) both include forming a respective first and second sub-level (110, 120, 210, 220), and
wherein the first sub-level (110) and the second sub-level (120) of the first interconnection level (100) include respective sets of conductive lines (111, 112, 121, 122) extending parallel to the first direction and being horizontally displaced in relation to each other, and
wherein the first sub-level (210) and the second sub-level (220) of the second interconnection level (200) include respective sets of conductive lines (211, 212, 221, 222) extending parallel to the second direction and being horizontally displaced in relation to each other.

5. A method according to claim 4, wherein both a vertical via (310) for interconnecting a line (112) of the first sub-level (110) of the first interconnection level (100) and a line (211) of the first sub-level (210) of the second interconnection level (200), and a vertical via (320) for interconnecting a line (121) of the second sub-level (120) of the first interconnection level (100) and a line (221) of the second sub-level (220) of the second interconnection level (200) are formed.

6. A method according to any of the preceding claims, wherein a line width of the set of lines of the first and second sub-levels (210, 220) of the second interconnection level (200) is greater than a line width of the set of lines of the first interconnection level (100), or wherein a line width of the set of lines of the first and second sub-levels (210, 220) of the first interconnection level (100) is greater than a line width of the set of lines of the second interconnection level (200).

## Patentansprüche

1. Verfahren zum Bilden einer mehrstufigen Zusammenschaltungsstruktur für eine Halbleitervorrichtung, wobei das Verfahren folgende Schritte umfasst:
Bilden einer ersten Zusammenschaltungsstufe (100), die eine Menge von leitfähigen Leitungen (111, 112, 113, 114) umfasst, die in einer ersten gemeinsamen horizontalen Ebene der ersten Zusammenschaltungsstufe (100) angeordnet sind und sich parallel zu einer ersten Richtung erstrecken,
Bilden einer zweiten Zusammenschaltungsstufe (200), wobei das Bilden der zweiten Zusammenschaltungsstufe (200) umfasst:
Bilden auf der ersten Zusammenschaltungsstufe (100) einer ersten Unterstufe (210) der zweiten Zusammenschaltungsstufe (200), wobei die erste Unterstufe (210) eine Menge von leitfähigen Leitungen (211, 212) umfasst, die in einer ersten gemeinsamen horizontalen Ebene der zweiten Zusammenschaltungsstufe (200) angeordnet sind und sich parallel zu einer zweiten Richtung erstrecken, die zu der ersten Richtung quer liegt,
Bedecken der ersten Unterstufe (210) mit einer dielektrischen Schicht (2020),
Bilden eines Durchkontaktierungslochs (418), das sich durch die dielektrische Schicht (2020) und die erste Unterstufe (210) bis zu einer Leitung (112) der Menge von Leitungen der ersten Zusammenschaltungsstufe (100) erstreckt,
Füllen des Durchkontaktierungslochs (418) mit einem leitfähigen Durchkontaktierungsmaterial, um eine Durchkontaktierung (320) zu bilden,
Bedecken der dielektrischen Schicht (2020) mit einer zusätzlichen dielektrischen Schicht (2021),
Bilden in der zusätzlichen dielektrischen Schicht einer Menge von Gräben zum Aufnehmen einer Menge von Leitungen der zweiten Unterstufe (220), wobei die Menge von Gräben derart gebildet ist, dass ein oberer Abschnitt der Durchkontaktierung (320) von einem Boden eines Grabens der Menge von Gräben vorsteht, und
Füllen der Menge von Gräben mit einem leitfähigen Leitungsmaterial, um die Menge von Leitungen der zweiten Unterstufe (220) zu bilden,
wobei die Menge von leitfähigen Leitungen (221, 222) der zweiten Unterstufe in einer zweiten gemeinsamen horizontalen Ebene der zweiten Zusammenschaltungsstufe (200) angeordnet ist, sich parallel zu der zweiten Richtung erstreckt und gegenüber der Menge von Leitungen (211, 212) der ersten Unterstufe (210) horizontal versetzt ist, und
wobei sich die Durchkontaktierung (320) an der Menge von Leitungen (211, 212) der ersten Unterstufe (210) vorbei in einem Raum zwischen einem Paar von angrenzenden Leitungen (211, 212) der Menge von Leitungen (211, 212) der ersten Unterstufe (210) erstreckt.

2. Verfahren nach Anspruch 1, wobei das Füllen des Durchkontaktierungslochs (412, 418) das Abscheiden des leitfähigen Durchkontaktierungsmaterials in dem Durchkontaktierungsloch durch einen stromlosen Abscheidungsprozess umfasst.

3. Verfahren nach Anspruch 1 oder 2, ferner umfassend das Bilden einer dielektrischen Auskleidung in dem Durchkontaktierungsloch (412, 418) vor dem Füllen des Durchkontaktierungslochs mit dem leitfähigen Durchkontaktierungsmaterial.

4. Verfahren nach einem der vorhergehenden Ansprüche, wobei das Bilden der ersten Zusammenschaltungsstufe (100) und das Bilden der zweiten Zusammenschaltungsstufe (200) beide das Bilden einer jeweiligen ersten und zweiten Unterstufe (110, 120, 210, 220) umfassen, und
wobei die erste Unterstufe (110) und die zweite Unterstufe (120) der ersten Zusammenschaltungsstufe (100) jeweilige Mengen von leitfähigen Leitungen (111, 112, 121, 122) umfassen, die sich parallel zu der ersten Richtung erstrecken und im Verhältnis zueinander horizontal verlagert sind, und
wobei die erste Unterstufe (210) und die zweite Unterstufe (220) der zweiten Zusammenschaltungsstufe (200) jeweilige Mengen von leitfähigen Leitungen (211, 212, 221, 222) umfassen, die sich parallel zu der zweiten Richtung erstrecken und im Verhältnis zueinander horizontal verlagert sind.

5. Verfahren nach Anspruch 4, wobei sowohl eine vertikale Durchkontaktierung (310) zum Zusammenschalten einer Leitung (112) der ersten Unterstufe (110) der ersten Zusammenschaltungsstufe (100) und einer Leitung (211) der ersten Unterstufe (210) der zweiten Zusammenschaltungsstufe (200), als auch eine vertikale Durchkontaktierung (320) zum Zusammenschalten einer Leitung (121) der zweiten Unterstufe (120) der ersten Zusammenschaltungsstufe (100) und einer Leitung (221) der zweiten Unterstufe (220) der zweiten Zusammenschaltungsstufe (200) gebildet werden.

6. Verfahren nach einem der vorhergehenden Ansprüche , wobei eine Leitungsbreite der Menge von Leitungen der ersten und zweiten Unterstufen (210, 220) der zweiten Zusammenschaltungsstufe (200) größer ist als eine Leitungsbreite der Menge von Leitungen der ersten Zusammenschaltungsstufe (100), oder wobei eine Leitungsbreite der Menge von Leitungen der ersten und zweiten Unterstufen (210, 220) der ersten Zusammenschaltungsstufe (100) größer ist als eine Leitungsbreite der Menge von Leitungen der zweiten Zusammenschaltungsstufe (200).

## Revendications

1. Procédé pour former une structure d'interconnexion à niveaux multiples pour un dispositif à semi-conducteur, le procédé comprenant :
la formation d'un premier niveau d'interconnexion (100) comprenant un ensemble de lignes conductrices (111, 112, 113, 114) disposées dans un premier plan horizontal commun du premier niveau d'interconnexion (100) et s'étendant parallèlement à une première direction,
la formation d'un deuxième niveau d'interconnexion (200), dans lequel la formation du deuxième niveau d'interconnexion (200) comprend :
la formation, sur le premier niveau d'interconnexion (100), d'un premier sous-niveau (210) du deuxième niveau d'interconnexion (200), le premier sous-niveau (210) comprenant un ensemble de lignes conductrices (211, 212) disposées dans un premier plan horizontal commun du deuxième niveau d'interconnexion (200) et s'étendant parallèlement à une deuxième direction transversale à la première direction,
le recouvrement du premier sous-niveau (210) avec une couche diélectrique (2020),
la formation d'un trou d'interconnexion (418) s'étendant à travers ladite couche diélectrique (2020) et le premier sous-niveau (210) jusqu'à une ligne (112) dudit ensemble de lignes du premier niveau d'interconnexion (100),
le remplissage du trou d'interconnexion (418) avec un matériau de via conducteur pour former un via (320),
le recouvrement de ladite couche diélectrique (2020) avec une couche diélectrique supplémentaire (2021),
la formation, dans ladite couche diélectrique supplémentaire, d'un ensemble de tranchées pour loger un ensemble de lignes du deuxième sous-niveau (220), dans lequel ledit ensemble de tranchées sont formées de manière à ce qu'une partie supérieure du via (320) fait saillie à partir d'un fond d'une tranchée dudit ensemble de tranchées, et
le remplissage dudit ensemble de tranchées avec un matériau de ligne conductrice pour former ledit ensemble de lignes du deuxième sous-niveau (220),
dans lequel ledit ensemble des lignes conductrices (221, 222) dudit deuxième sous-niveau sont disposées dans un deuxième plan horizontal commun du deuxième niveau d'interconnexion (200), s'étendent parallèlement à la deuxième direction et sont décalées horizontalement par rapport à l'ensemble des lignes (211, 212) du premier sous-niveau (210), et
dans lequel le via (320) s'étend au-delà dudit ensemble de lignes (211, 212) du premier sous-niveau (210) dans un espace entre une paire de lignes adjacentes (211, 212) dudit ensemble de lignes (211, 212) du premier sous-niveau (210).

2. Procédé selon la revendication 1, dans lequel le remplissage du trou d'interconnexion (412, 418) comprend le dépôt du matériau de via conducteur dans le trou d'interconnexion grâce à un processus de dépôt autocatalytique.

3. Procédé selon la revendication 1 ou 2, comprenant en outre la formation d'un revêtement diélectrique dans le trou d'interconnexion (412, 418) avant de remplir le trou d'interconnexion avec le matériau de via conducteur.

4. Procédé selon l'une quelconque des revendications précédentes, dans lequel la formation du premier niveau d'interconnexion (100) et la formation du deuxième niveau d'interconnexion (200) comprennent toutes deux la formation d'un premier et d'un deuxième sous-niveau (110, 120, 210, 220) respectif, et
dans lequel le premier sous-niveau (110) et le deuxième sous-niveau (120) du premier niveau d'interconnexion (100) comprennent des ensembles respectifs de lignes conductrices (111, 112, 121, 122) s'étendant parallèlement à la première direction et décalés horizontalement les uns par rapport aux autres, et
dans lequel le premier sous-niveau (210) et le deuxième sous-niveau (220) du deuxième niveau d'interconnexion (200) comprennent des ensembles respectifs de lignes conductrices (211, 212, 221, 222) s'étendant parallèlement à la deuxième direction et décalés horizontalement les uns par rapport aux autres.

5. Procédé selon la revendication 4, dans lequel à la fois un via vertical (310) pour l'interconnexion d'une ligne (112) du premier sous-niveau (110) du premier niveau d'interconnexion (100) et d'une ligne (211) du premier sous-niveau (210) du deuxième niveau d'interconnexion (200) , et un via vertical (320) pour l'interconnexion d'une ligne (121) du deuxième sous-niveau (120) du premier niveau d'interconnexion (100) et d'une ligne (221) du deuxième sous-niveau (220) du deuxième niveau d'interconnexion (200) sont formés.

6. Procédé selon l'une quelconque des revendications précédentes, dans lequel une largeur de ligne de l'ensemble de lignes des premier et deuxième sous-niveaux (210, 220) du deuxième niveau d'interconnexion (200) est supérieure à une largeur de ligne de l'ensemble de lignes du premier niveau d'interconnexion (100), ou dans lequel une largeur de ligne de l'ensemble de lignes des premier et deuxième sous-niveaux (210, 220) du premier niveau d'interconnexion (100) est supérieure à une largeur de ligne de l'ensemble de lignes du deuxième niveau d'interconnexion (200).
